# EUROPÄISCHE PATENTANMELDUNG

(11) **EP 1 109 319 A2**
(43) Veröffentlichungstag der Anmeldung: **20.06.2001**
(21) Anmeldenummer: 00125426.7
(22) Anmeldetag: 20.11.2000
(51) Int. Cl.: H03L 7/23

(54) **Taktsignal-Erzeuger-Umsetzer-Einrichtung**

(30) Priorität: 10.12.1999 DE 19959714
(71) Anmelder: SIEMENS AKTIENGESELLSCHAFT, 80333 München (DE)
(72) Erfinder: Dauth, Fritz-Jörg, 83607 Holzkirchen (DE)

(57) **Zusammenfassung**

Die Einrichtung dient zum Umsetzten eines Taktsignals (TS1) in ein zweites Taktsignal (TS2) mit einer unterschiedlichen Taktrate, um ein erstes Datensignal (DS1) in ein zweites Datensignal (DS2) mit einer veränderten Datenrate umsetzten zu können. Durch Steuerung der Frequenzteiler insbesondere im Rückkopplungsweg der Phasenregelkreise ist eine Anpassung an die verschiedenen Datenraten und eine Umsetzung zwischen beiden Datensignalen DS1 in DS2, bzw. DS2 in DS1 möglich.

## Beschreibung

Die Erfindung betrifft eine Taktsignal-Erzeuger-Umsetzer-Einrichtung, mit deren Hilfe ein erstes Datensignal in ein zweites Datensignal mit einer abweichenden Datenrate umgesetzt wird.

Zur mittels Fehlerkorrektur gesicherten Datenübertragung kann die Datenrate erhöht werden; empfangsseitig kann aus dem übertragenen Signal wieder das ursprüngliche Datensignal gewonnen werden.

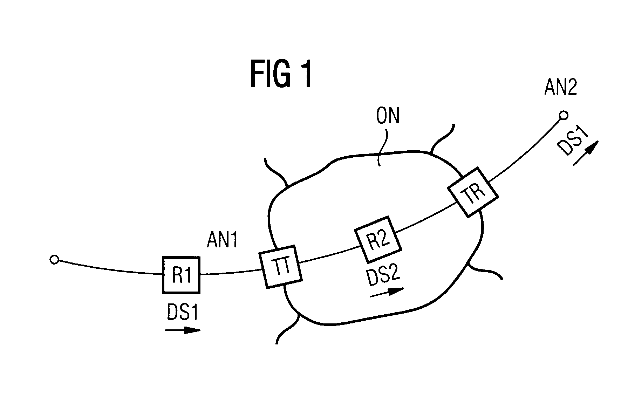

So wird beispielsweise für die Übertragung von SDH-Signalen (Synchrone Digitale Hierarchie) über Unterseekabel nach ITU-G. 975 empfohlen, eine Fehlerkorrektur einzuführen, wozu die Übertragungsrate auf 15/14 der ursprünglichen Datenrate erhöht wird. Anhand von Figur 1 soll der Einsatz der entsprechenden Einrichtungen erläutert werden. Von einem Teilnehmer wird ein erstes Datensignal in einem ersten Accessnetz AN1 übertragen. Bereits hier kann es notwendig sein, einen ersten Regenerator R1 einzusetzen. Dieser sendet ein regeneriertes Datensignal weiter, das in einem optischen Netz ON mit Hilfe von Korrekturbits gesichert übertragen wird. Im Umsetzerterminal TT wird aus dem Datensignal DS zunächst ein zugeordnetes Taktsignal gewonnen und dieses in ein Taktsignal mit höherer Datenrate, das der Übertragungsrate eines zweiten Korrekturbits aufweisendem Datensignal DS2 entspricht, umgesetzt. Ein weiterer Regenerator R2 kann zur Amplituden-, Pulsform- und Taktregeneration im optischen Netz erforderlich sein. Im Rückumsetzerterminal TR wird zunächst aus dem Datensignal DS2 ein zugeordnetes zweites Taktsignal gewonnen und in ein erstes Taktsignal TS1 umgesetzt, das wiederum dem zurückgewonnenen ersten Datensignal DS1 zugeordnet ist.

Aufgabe der Erfindung ist es, insbesondere für das Sendeterminal und das Empfangsterminal, eine geeignete Taktsignal-Erzeuger-Umsetzer-Einrichtung anzugeben. Diese soll auch in den Regeneratoren verwendet werden können.

Diese Aufgabe wird durch die Taktsignal-Erzeuger-Umsetzer-Einrichtung gemäß Patentanspruch 1 gelöst.

Durch Umschaltmöglichkeit kann diese Einrichtung universell eingesetzt werden. Dies ist der wesentliche Vorteil der Einrichtung.

Vorteilhafte Weiterbildungen sind in den Unteransprüchen angegeben.

Ausführungsbeispiele der Erfindung werden anhand von Figuren näher erläutert.

Es zeigen:
- Figur 1: einen Anwendungsfall der Erfindung,
- Figur 2: ein erstes Ausführungsbeispiel der Erfindung, und
- Figur 3: ein zweites Ausführungsbeispiel.

Die erfindungsgemäße Einrichtung soll, wie bereits in der Beschreibungseinleitung anhand von **Figur 1** erläutert, insbesondere an den Schnittstellen zwischen ungesicherten optischen Netzen AN1, AN2 und einem durch Fehlerkorrektur gesicherten (und in Netzen der Synchronen Digitalen Hierarchie, SDH, mittels OH-Byte überwachbarem) optischen Netz ON eingesetzt werden.

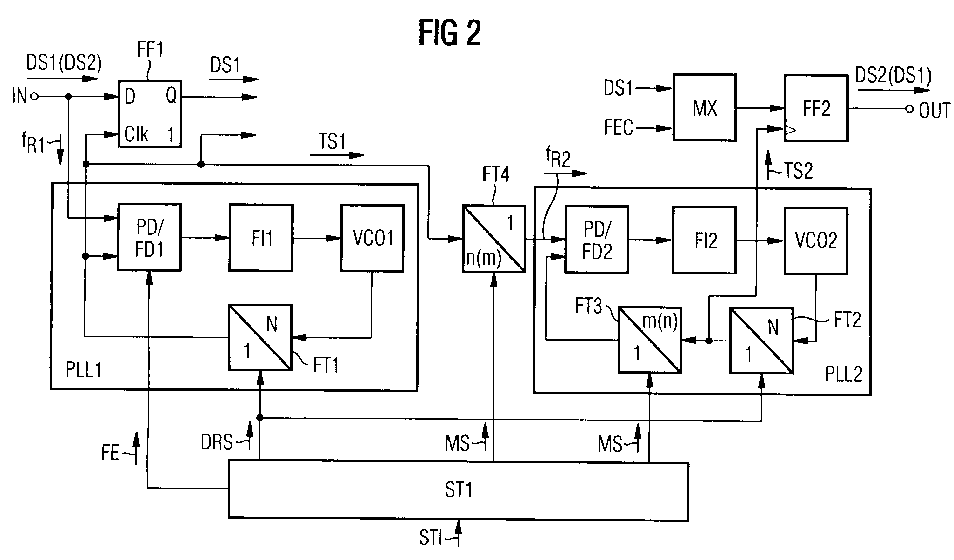

In **Figur 2** ist die erfindungsgemäße Taktsignal-Erzeuger-Umsetzer-Einrichtung dargestellt. Sie enthält im wesentlichen zwei Phasenregelkreise PLLl und PLL2 sowie eine Steuerung ST1. Der erste Phasenregelkreis PLLl enthält einen Phasen-Frequenz-Diskriminator PD/FD1, ein Filter FI1, einen ersten steuerbaren Oszillator VCOl und im Rückkopplungskreis einen einstellbaren ersten Frequenzteiler FT1. Dem Phasen/Frequenz-Diskriminator PD/FD1 wird ein erstes Datensignal DS1 über einen Eingang als Referenzsignal f_{R1} zugeführt. Außerdem Er kann er durch ein Frequenz-Einstellsignal FE abgestimmt werden. Von der Steuerung ST1, die vom Netzwerkmanagement Steuerinformationen STI erhält, wird durch ein Datenrate-Steuersignal DRS der erste Frequenzteiler FT1 entsprechend der Datenrate des Datensignals DS1 eingestellt. Dieser Frequenzteiler ermöglicht den Einsatz der Schaltung bei den unterschiedlichsten Datenraten. Durch den Phasen/Frequenz-Diskriminator PD/FD1 wird ein sicheres Einrasten des ersten Phasenregelkreises PLL1 erreicht und das erste Taktsignal TS1 erzeugt. Mit diesem wird das Datensignal DS1 in einer Abtastkippstufe FF1 zwischengespeichert.

Der zweite Phasenregelkreis PLL2 erhält das erste Taktsignal TS1 oder ein hieraus durch Frequenzteilung abgeleitetes Signal als zweites Referenzsignal F_{R2}. Dieser Phasenregelkreis soll zunächst eine etwas erhöhte Datenrate liefern. Hierzu sind im Rückkopplungskreis ein zweiter Frequenzteiler FT2 und ein dritter Frequenzteiler FT3 angeordnet. Der zweite Frequenzteiler FT2 weist das gleiche Teilungsverhältnis wie der erste Frequenzteiler FT1 auf und wird gemeinsam mit diesem entsprechend der Datenrate des anliegenden Datensignals DS1 eingestellt. Der dritte Frequenzteiler FT3 weist ein Teilungsverhältnis von m : 1 auf, während der dem zweiten Phasen/Frequenz-Diskriminator PD/FD2 vorgeschaltete Frequenzteiler FT4 ein Teilungsverhältnis von n : 1 aufweist. Entsprechend dem Teilungsverhältnis m : n, hier 15/14, wird somit ein zweites Taktsignal TS2 mit erhöhter Taktrate erzeugt. Mit diesem Taktsignal werden die zwischengespeicherten Daten des ersten Datensignals DS1 und zusätzliche Korrekturbits FEC über einen Multiplexer zusammengefaßt und über eine Sendekippstufe FF2 als zweites Datensignal DS2 ausgegeben. Werden der dritte Frequenzteiler FT3 und der vorgeschaltete Frequenzteiler FT4 einstellbar gemacht, so kann die Taktfrequenz des zweiten Taktsignals TS2 gegenüber der ersten Taktfrequenz TS1 gleich bleiben, erhöht oder erniedrigt werden. Im angegebenen Anwendungsfall kann dieselbe Einrichtung genutzt werden, um ein zweites Datensignal DS2 in einem Empfangsterminal TR (Fig. 1) in ein erstes Datensignal DS1 umzusetzen (ein erforderlicher Zwischenspeicher ist nicht dargestellt). Hierzu müssen lediglich die Teilungsverhältnisse der Frequenzteiler FT3 und FT4 ausgetauscht werden. Falls beide Teilungsverhältnisse gleich sind, kann die Einrichtung als Regenerator eingesetzt werden.

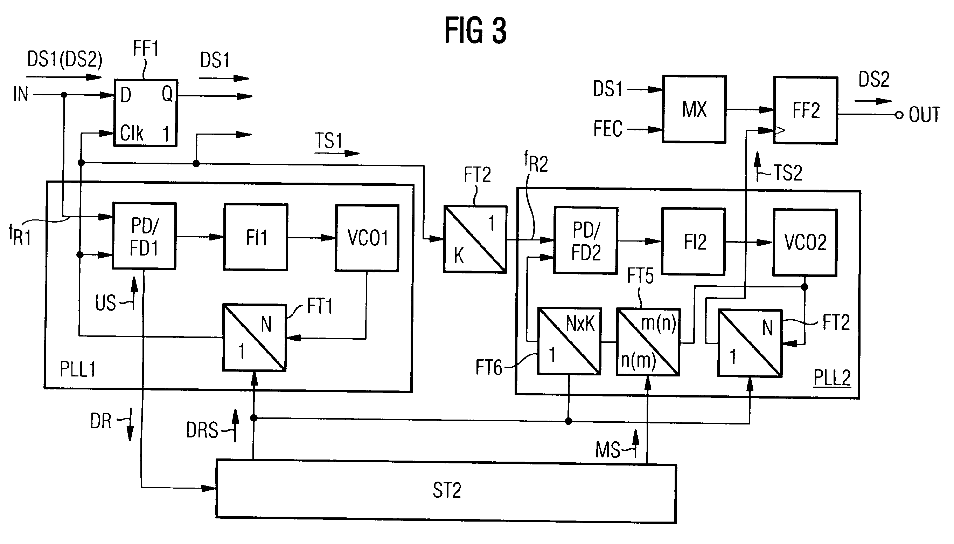

In **Figur 3** ist eine Variante des zweiten Phasenregelkreises dargestellt. Die Rückgewinnung erfolgt hier mit Hilfe eines fünften Frequenzteilers FT5, der ein gebrochen rationales Teilungsverhältnis m : n oder n : m aufweist. Dieser ist zusammen mit einem sechsten Frequenzteiler FT6 in den Rückkopplungsweg des Phasenregelkreises eingeschaltet. Der sechste Frequenzteiler weist ein Teilungsverhältnis von (NxK) : 1 auf und ist von dem Moden-Steuersignal MS einstellbar. Das zweite Referenzsignal F_{R2} wird über einen vorgeschalteten Frequenzteiler FT7 mit dem Teilungsverhältnis k : 1 gewonnen. Der Frequenzteiler FT6 ist zweckmäßig, um die durch den gebrochen rationalen Frequenzteiler FT5 verursachten Phasensprünge auszugleichen. Abhängig von dem Teilungsverhältnissen m : n und N : 1 kann eventuell auf eine Frequenzteilung durch den Faktor k und somit auch auf den vorgeschalteten Frequenzteiler FT7 verzichtet werden. Das zweite Taktsignal wird wieder mit Hilfe des Frequenzteilers FT2 gewonnen.

Hier ist eine Variante ST2 der Steuerung vorgesehen, die keine Information über die Datenrate des empfangenen Datensignals hat. Diese wird mit Hilfe eines externen Referenzsignals VS vom Phasen/Frequenzdiskriminator ermittelt. Die weitere Einstellung erfolgt wie bereits beschrieben, je nachdem ob die Datenrate erhöht oder erniedrigt werden soll.

## Patentansprüche

1. Taktsignal-Erzeuger-Umsetzer-Einrichtung mit einem ersten Phasenregelkreis (PLL1) zur Gewinnung eines ersten Taktsignals (TS1) aus jeweils einem von mehreren Datensignalen (DS1) mit unterschiedlichen Datenraten, wobei jeweils ein Datensignal (DS1) als Referenzsignal (f_{R1}) dem ersten Phasenregelkreis (PLL2) zugeführt wird, in dessen Rückkopplungsweg ein einstellbarer erster Frequenzteiler (FT1) zur groben Anpassung an die unterschiedlichen Datenraten eingeschaltet ist, und mit einem zweiten Phasenregelkreis (PLL2) zur Umsetzung des ersten Taktsignals (TS1) in ein zugeordnetes zweites Taktsignal (TS2) mit einer anderen Taktfrequenz, wobei das erste Taktsignal (TS1) als zweites Referenzsignal (f_{R2}) über einen vorgeschalteten Frequenzteiler (FT4) dem zweiten Phasenregelkreis (PLL2) zugeführt wird, in dessen Rückkopplungsweg ein zweiter einstellbarer Frequenzteiler (FT2) zur groben Anpassung an die verschiedenen Datenraten der Datensignale (DS1) und ein dritter Frequenzteiler (FT3, FT5) zur Erzeugung des zweiten Taktsignals (TS2) mit einer anderen Taktfrequenz eingeschaltet ist.

2. Taktsignal-Erzeuger-Umsetzer-Einrichtung nach Anspruch 1,
**dadurch gekennzeichnet**,
daß der im Rückkopplungsweg des zweiten Phasenregelkreises (PLL2) angeordnete dritte Frequenzteiler (FT3) und der das zweite Referenzsignal (f_{R2}) liefernde vorgeschaltete Frequenzteiler (FT4) derart einstellbar sind, daß sowohl eine Erhöhung als auch eine Verringerung der Taktrate des zweiten Taktsignals (TS2) gegenüber der des ersten Taktsignals (TS1) einstellbar ist.

3. Taktsignal-Erzeuger-Umsetzer-Einrichtung nach Anspruch 1,
**dadurch gekennzeichnet**,
daß im Rückkopplungsweg des zweiten Phasenregelkreises (PLL2) ein fünfter Frequenzteiler (FT5) mit einem gebrochen rationalen Teilungsverhältnis vorgesehen ist.

4. Taktsignal-Erzeuger-Umsetzer-Einrichtung nach Anspruch 3,
**dadurch gekennzeichnet**,
daß das Teilungsverhältnis des fünften Frequenzteilers (FT5) einstellbar ist, so daß sowohl eine Erhöhung als auch eine Verringerung der Taktfrequenz des zweiten Taktsignals (TS2) gegenüber der des ersten Taktsignals (TS1) einstellbar ist.

5. Taktsignal-Erzeuger-Umsetzer-Einrichtung nach Anspruch 3 oder 4,
**dadurch gekennzeichnet**,
daß dem fünften Frequenzteiler (FT5) ein sechster Frequenzteiler (FT6) nachgeschaltet ist.

6. Taktsignal-Erzeuger-Umsetzer-Einrichtung nach Anspruch 2 oder 5,
**dadurch gekennzeichnet**,
daß der Frequenzteiler (FT3, FT5) im Rückkopplungsweg des zweiten Phasenregelkreises (PLL2) zusätzlich derart einstellbar ist, daß die Taktfrequenzen des ersten Taktsignals (TS1) und des zweiten Taktsignals (TS2) gleich sind.

7. Taktsignal-Erzeuger-Umsetzer-Einrichtung nach einem der vorhergehenden Ansprüchen,
**dadurch gekennzeichnet**,
daß eine Steuerung (ST1) zur Einstellung der einstellbaren Frequenzteiler (FT3, FT5, FT6) vorgesehen ist, der die Datenrate des ersten Datensignals (DS1) / die Taktrate des ersten Taktsignals (TS1) und die Datenrate des zweiten Datensignals (DS2) / die Taktrate des zweiten Taktsignals (TS2) bekannt sind.

8. Taktsignal-Erzeuger-Umsetzer-Einrichtung nach Anspruch 1 bis 6,
**dadurch gekennzeichnet**,
daß die Datenrate (DR) des ersten Datensignals (DS1) durch einen Frequenzdiskriminator des ersten Phasenregelkreises (PLL1) und eine Steuerung (ST2) ermittelt wird und der erste Frequenzteiler (FT1) des ersten Phasenregelkreises (PLL1) entsprechend eingestellt wird, und daß aufgrund von gespeicherter oder übertragener Zusatzinformation der zweite Phasenregelkreis (PLL2) eingestellt wird.

9. Taktsignal-Erzeuger-Umsetzer-Einrichtung nach einem der vorhergehenden Ansprüche,
**dadurch gekennzeichnet**,
daß gleiche steuerbare Oszillatoren (VCO1, VCO2) in beiden Regelkreisen (PLL1, PLL2) vorgesehen sind.
